# EUROPEAN PATENT APPLICATION

(11) **EP 3 943 641 A1**
(43) Date of publication of application: **26.01.2022**
(21) Application number: 21186267.7
(22) Date of filing: 16.07.2021
(51) Int. Cl.: C23C 28/04, C23C 28/00, C23C 4/11, C23C 4/12, C23C 4/134, C23C 4/137, C23C 14/08, C23C 14/34, F01D 5/28

(54) **CMAS-RESISTANT THEMAL BARRIER COATING FOR PART OF GAS TURBINE ENGINE**

(30) Priority: 22.07.2020 US 202016936189
(71) Applicant: Honeywell International Inc., Charlotte, NC 28202 (US)
(72) Inventor: TOLPYGO, Vladimir, Charlotte, 28202 (US); VAN SLUYTMAN, Jason, Charlotte, 28202 (US); CHRISTOPHER, James, Charlotte, 28202 (US); LUTZ, Bradley, Charlotte, 28202 (US); JORGENSEN, David, Charlotte, 28202 (US)
(74) Representative: LKGlobal UK Ltd.

(57) **Abstract**

A method of manufacturing a part with a CMAS-resistant thermal barrier coating (TBC) includes providing a part body having a surface and providing a source of coating material. The coating material includes a thermal protection material and a CMAS-reactive material. The method also includes delivering the coating material from the source toward the surface of the part body to form the CMAS-resistant TBC on the surface. The CMAS-resistant TBC includes both the thermal protection material and the CMAS-reactive material. The CMAS-reactive material is included as a substantially uniform distribution within the thermal protection material.

## Description

### TECHNICAL FIELD

The present disclosure generally relates to a thermal barrier coating and, more particularly, relates to a CMAS-resistant thermal barrier coating for a part, such as a part of a gas turbine engine.

### BACKGROUND

Many components, such as gas turbine engines, include parts with a thermal barrier coating (TBC). The TBC is usually made of a ceramic material, has low thermal conductivity, and is applied on a part for thermally protecting it in a high-temperature environment. For example, a turbine section of a gas turbine section may include blades, vanes, or other components made of a material (e.g., a superalloy) that is protected from high-temperature gases by the TBC. Furthermore, the TBC may be deposited onto a bond coat that provides oxidation protection of the part.

However, many TBCs have limited durability and robustness. The TBC may degrade prematurely, for example, due to exposure to calcium magnesium aluminosilicate (i.e., CMAS). A gas turbine engine may ingest sand, ash, and/or dust, and these fine particles may become molten or volatize as hydroxides and react with the TBC. In other words, there may be liquid-phase and/or vapor-phase infiltration of CMAS constituents into the TBC over time. This infiltration of CMAS may result in stiffening and loss of strain compliance of the TBC resulting in TBC spallation on cooling. In addition, there may be weakening of the bond between the TBC and the bond coat due to chemical reactions between the thermally-grown oxide (TGO) on the bond coat surface and CMAS constituents.

Additionally, existing manufacturing methods for forming parts with durable and robust TBCs are limited. These methods can be resource-intensive, expensive, time consuming, or otherwise disadvantageous.

Accordingly, there is a longstanding and on-going need for a more durable and robust TBC. Specifically, there is a need for an improved CMAS-resistant TBC, which significantly reduces CMAS infiltration into the CMAS. Additionally, there is a need for improved manufacturing methods, which are used to provide these types of CMAS-resistant TBCs, which utilize improved materials, implements, etc., and/or which are increasingly cost-effective.

### BRIEF SUMMARY

This summary is provided to describe select concepts in a simplified form that are further described in the Detailed Description. This summary is not intended to identify key or essential features of the claimed subject matter, nor is it intended to be used as an aid in determining the scope of the claimed subject matter.

A method of manufacturing a part with a CMAS-resistant thermal barrier coating (TBC) is disclosed. The method includes providing a part body having a surface and providing a source of coating material. The coating material includes a thermal protection material and a CMAS-reactive material. The method also includes delivering the coating material from the source toward the surface of the part body to form the CMAS-resistant TBC on the surface, wherein the CMAS-resistant TBC includes both the thermal protection material and the CMAS-reactive material, and wherein the CMAS-reactive material is included as a substantially uniform distribution within the thermal protection material.

Also, a thermally coated part is disclosed that includes a part body and a CMAS-resistant thermal barrier coating (TBC) on the part body. The CMAS-resistant TBC includes a thermal protection material and a CMAS-reactive material. The CMAS-reactive material is included in a substantially uniform distribution within the thermal protection material.

Other desirable features and characteristics of the apparatus and method will become apparent from the subsequent detailed description and the appended claims, taken in conjunction with the accompanying drawings and the preceding background.

### BRIEF DESCRIPTION OF THE DRAWINGS

The present disclosure will hereinafter be described in conjunction with the following drawing figures, wherein like numerals denote like elements, and wherein:
FIG. 1 is a schematic view of a gas turbine engine according to example embodiments of the present disclosure;
FIG. 2 is a schematic cross-sectional view of a part with a thermal barrier coating according to example embodiments of the present disclosure;
FIG. 3 is a schematic illustration of operation of the TBC of FIG. 2 when exposed to CMAS materials;
FIG. 4 is a schematic cross-sectional view of a part with a thermal barrier according to additional embodiments of the present disclosure;
FIG. 5 is a schematic view representing a method of manufacturing the part with the TBC of FIG. 2 according to example embodiments of the present disclosure; and
FIG. 6 is a schematic view representing the method of manufacturing the part with the TBC of FIG. 2 according to additional example embodiments of the present disclosure.

### DETAILED DESCRIPTION

The following detailed description is merely exemplary in nature and is not intended to limit the present disclosure or the application and uses of the present disclosure. As used herein, the word "exemplary" means "serving as an example, instance, or illustration." Thus, any embodiment described herein as "exemplary" is not necessarily to be construed as preferred or advantageous over other embodiments. All of the embodiments described herein are exemplary embodiments provided to enable persons skilled in the art to make or use the present disclosure and not to limit the scope of the present disclosure which is defined by the claims. Furthermore, there is no intention to be bound by any expressed or implied theory presented in the preceding technical field, background, brief summary, or the following detailed description.

Broadly, embodiments of the present disclosure include an improved thermal barrier coating (TBC) that is largely resistant to deleterious effects of CMAS exposure. This coating may include CMAS-reactive material provided therein. In some embodiments, the TBC of the present disclosure may have one or more first materials that exhibit low thermal conductivity as well as CMAS-reactive material provided with the first material(s). The majority of the TBC (by weight percentage) may be the first material(s) and the CMAS-reactive material may be included at a significantly lower amount (e.g., a trace amount). The TBC of the present disclosure may be considered "doped" with the CMAS-reactive material.

Furthermore, the CMAS-reactive TBC of the present disclosure may be formed according to an improved manufacturing method. The manufacturing method may provide high efficiency, accuracy, and repeatability. These methods may also reduce manufacturing costs. In some embodiments, the method may include applying the first material(s) (i.e., thermal protection material, low-thermal conductivity material) together with CMAS-reactive material to build up, apply, and provide the doped-TBC layer, substantially simultaneously (in a single continuous manufacturing process).

In some embodiments, the CMAS-reactive compound is an aluminum-containing material, such as aluminum oxide (i.e., alumina, Al₂O₃). Also, the thermal protection material (i.e., the first material) may be a low-thermal conductivity material, such as a rare-earth-doped zirconia material (e.g., a yttria- or other rare-earth-oxide-stabilized zirconia ceramic material). Furthermore, in some embodiments, the CMAS-reactive material is included in relatively small amounts. For example, the CMAS-reactive material is included at approximately one to five percent (1-5%) by weight of the CMAS-resistant TBC. In some embodiments, the CMAS-reactive material is included at approximately two to four percent (2-4%) (e.g., alumina is included at approximately 2-4% weight of the TBC). The CMAS-reactive material is present in the CMAS-resistant TBC not as a discrete layer (or plurality of layers), nor as individual particles (i.e., particles greater than one micron in size), but may be substantially evenly (uniformly) distributed in the low-thermal conductivity material. The CMAS-reactive material may be dissolved in ceramic solid solution or precipitated as nano-size inclusions inside the thermal protection material of the CMAS-resistant TBC. Accordingly, if CMAS is present on the surface or inside the TBC, it may react with the CMAS-reactive material, which limits further infiltration or penetration of the CMAS into the TBC.

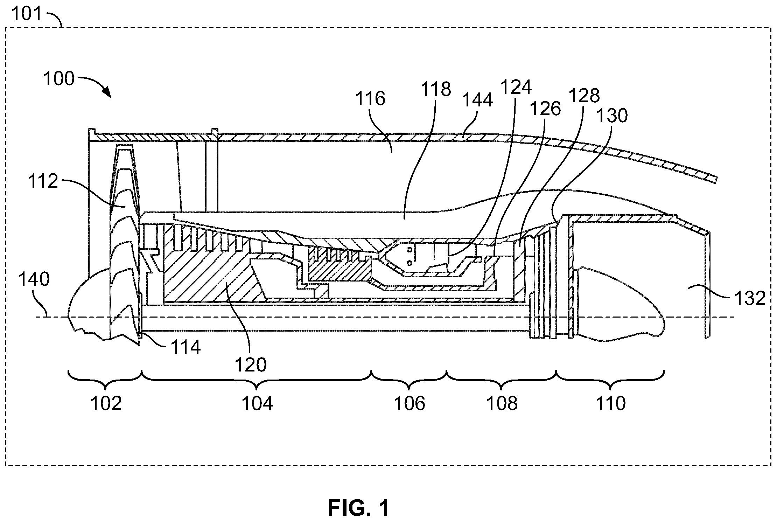

With reference to FIG. 1, a partial, cross-sectional view of an exemplary gas turbine engine 100 is shown with the remaining portion of the gas turbine engine 100 being substantially axisymmetric about a longitudinal axis 140, which also defines an axis of rotation for the gas turbine engine 100. In the depicted embodiment, the gas turbine engine 100 is an annular multi-spool turbofan gas turbine jet engine within an aircraft (represented schematically at 101), although features of the present disclosure may be included in other configurations, arrangements, and/or uses. For example, in other embodiments, the gas turbine engine 100 may assume the form of a non-propulsive engine, such as an Auxiliary Power Unit (APU) deployed onboard the aircraft 101, or an industrial power generator.

In this example, with continued reference to FIG. 1, the gas turbine engine 100 includes a fan section 102, a compressor section 104, a combustor section 106, a turbine section 108, and an exhaust section 110. In one example, the fan section 102 includes a fan 112 mounted on a rotor 114 that draws air into the gas turbine engine 100 and compresses it. A fraction of the compressed air exhausted from the fan 112 is directed through the outer bypass duct 116 and the remaining fraction of air exhausted from the fan 112 is directed into the compressor section 104. The outer bypass duct 116 is generally defined by an outer casing 144 that is spaced apart from and surrounds an inner bypass duct 118.

In the embodiment of FIG. 1, the compressor section 104 includes one or more compressors 120. The number of compressors 120 in the compressor section 104 and the configuration thereof may vary. The one or more compressors 120 sequentially raise the pressure of the air and direct a majority of the high-pressure fluid or air into the combustor section 106. In the combustor section 106, which includes a combustion chamber 124, the high-pressure air is mixed with fuel and is combusted. The high-temperature combustion air or combustive gas flow is directed into the turbine section 108. In this example, the turbine section 108 includes three turbines disposed in axial flow series, namely, a high-pressure turbine 126, an intermediate pressure turbine 128, and a low-pressure turbine 130. However, it will be appreciated that the number of turbines, and/or the configurations thereof, may vary. In this embodiment, the high-temperature combusted air from the combustor section 106 expands through and rotates each turbine 126, 128, and 130. The combustive gas flow then exits the turbine section 108 for mixture with the cooler bypass airflow from the outer bypass duct 116 and is ultimately discharged from the gas turbine engine 100 through the exhaust section 132. As the turbines 126, 128, 130 rotate, each drives equipment in the gas turbine engine 100 via concentrically disposed shafts or spools.

In some situations, CMAS may be ingested at the air inlet (through the fan section 102) and further delivered into the combustor and turbine sections 106, 108. The CMAS may turn molten or volatize as hydroxides. Embodiments of TBCs discussed below may be CMAS-resistant to avoid deleterious effects from this exposure to CMAS.

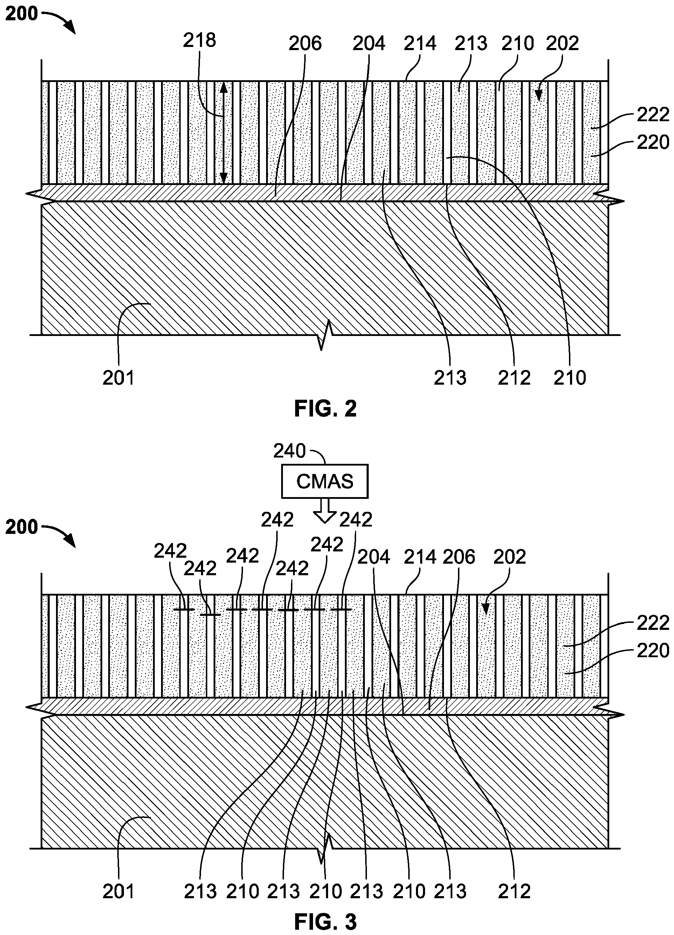

Referring now to FIG. 2, a part 200 of the gas turbine engine 100 is shown schematically. It will be appreciated that the part 200 may be one of a variety of parts of the gas turbine engine 100 without departing from the scope of the present disclosure. The part 200 may have an airfoil shape. In some embodiments, the part 200 may be included in an area of the engine 100 subjected to high-temperature environments. Thus, the part 200 may be a component of the combustor section 106, a component of the turbine section 108, etc. More specifically, the part 200 may be a blade, a vane, or other component of the turbine section 108. It will also be appreciated that the part 200 may be a component of something other than a gas turbine engine 100 without departing from the scope of the present disclosure.

The part 200 may include a body 201 that defines the majority of the part 200. The body 201 may be made of any suitable material. For example, in some embodiments, the body 201 may be made of or include a metallic superalloy (e.g., a nickel-based superalloy). The body 201 may also include an outer surface 204. The outer surface 204 may be contoured or substantially flat. For example, the outer surface 204 may at least partly define an airfoil shape.

The part 200 may also include a bond coat 206. The bond coat 206 may be a thin metallic coating on the outer surface 204. In some embodiments, the bond coat 206 may be further covered by or include a thermally-grown oxide material, such as aluminum oxide. Thus, the bond coat 206 may be a metallic bond coat that provides oxidation protection of the part 200.

Furthermore, the part 200 may include at least one CMAS-resistant TBC 202. The TBC 202 may include an inner boundary 212 that faces the bond coat 206 and the surface 204 and an outer boundary 214 that faces away from the bond coat 206 and the surface 204. The TBC 202 may have a thickness 218 that is between approximately 0.1 to 2 mm.

The TBC 202 may be layered on the bond coat 206 with the bond coat 206 disposed in a thickness direction between the inner boundary 212 of the TBC 202 and the outer surface 204 of the body 201. As such, the bond coat 206 bonds the TBC 202 to the outer surface 204 of the body 201.

In general, the TBC 202 may be a ceramic material (i.e., formed primarily from a ceramic), and the TBC 202 may have low thermal conductivity for thermally protecting the underlying body 201. The microstructure of the TBC 202 may include a plurality of voids 210 (i.e., pores, gaps, etc.), as represented schematically in FIG. 2. More specifically, the TBC 202 may define a plurality of columns 213 that extend longitudinally away from the body 201 of the part 200, and the voids 210 may be defined between the respective columns 213. The voids 210 may increase the strain compliance of the TBC 202. For example, in some embodiments, the body 201 may have a significantly higher rate of thermal expansion than the TBC 202. However, the voids 210 may provide a degree of strain compliance to the TBC 202 for accommodating the thermal mismatch.

Although the columns 213 and voids 210 are shown in FIG. 2 as having a uniform size, a uniform alternating arrangement, etc., those having ordinary skill in the art will recognize that those features are illustrated schematically for simplicity. In actuality, the columns 213 and voids 210 may not exhibit uniform size, arrangement, etc. Furthermore, the columns 213 and voids 210 may not extend continuously from the bond coat 206; instead, some of the columns 213 and/or voids 210 may extend from the bond coat 206 and may be covered over in the thickness direction by other columns 213 and/or voids 210. In other embodiments, the plurality of voids 210 may be represented as open, elongate gaps (i.e., cracks) between localized, elongated, (e.g., pancake-shaped splats) of the TBC. The voids 210 may define randomly-distributed pores without any particular orientation relative to the outer surface 204. In additional embodiments, the plurality of voids 210 may be represented as open gaps or cracks oriented substantially perpendicular to the outer surface 204 of the part body 201. Moreover, as will be discussed below, instead of including columns 213, the TBC 202 may be configured and arranged differently without departing from the scope of the present disclosure. Additionally, as will be discussed, the TBC 202 of the present disclosure may be manufactured in a variety of ways without departing from the scope of the present disclosure; therefore, the arrangement of the TBC 202 (i.e., the columns 213 or other structure) may have different arrangements without departing from the scope of the present disclosure.

The TBC 202 may be made from a variety of materials without departing from the scope of the present disclosure. In general, the TBC 202 may include a thermal protection material 220 and an amount of CMAS-reactive material 222.

The thermal protection material 220 may exhibit relatively low thermal conductivity. The thermal protection material 220 may exhibit significantly lower thermal conductivity than the material of the part body 201. As such, the thermal protection material 220 may thermally protect the underlying body 201. In some embodiments, the thermal protection material 220 is a rare-earth-doped zirconia. In other words, the zirconia may be doped by an oxide of at least one rare-earth element (e.g., Y, Yb, Sc, Gd, Er, La, etc.). Also, the thermal protection material 220 may be a yttria-stabilized zirconia (YSZ) or other rare-earth-stabilized zirconia.

The CMAS-reactive material 222 may be provided in a substantially uniform (i.e., even) distribution within the TBC 202 from the inner boundary 212 to the outer boundary 214. Generally, the CMAS-reactive material 222 may be chemically reactive with CMAS materials, but the CMAS-reactive material 222 may be nonreactive (inert, chemically neutral) to the thermal protection material 220.

In some embodiments, the CMAS-reactive material 222 may be an aluminum-containing material, such as aluminum oxide (i.e., alumina, Al₂O₃), which may be advantageous due to its wide and low-cost availability. Also, as stated above, the thermal protection material 220 of the TBC 202 may include a rare-earth-doped zirconia, such as yttria-stabilized zirconia (YSZ). In these embodiments, the alumina material 222 does not chemically react or dissolve in the YSZ material 220. Also, the alumina material 222 remains thermodynamically stable above a predetermined temperature limit (e.g., a typical operating temperature environment for the part 200).

The TBC 202 may include a predetermined amount of the CMAS-reactive material 222. For example, alumina may be included as the CMAS-reactive material 222 at a weight percentage between two and four percent (2-4%) of the TBC 202. At these amounts, the CMAS-reactive material 222 may provide effective CMAS protection, and yet the TBC 202 may still exhibit sufficiently low thermal conductivity, effective strain compliance, and high mechanical integrity.

When initially formed (FIG. 2), the TBC 202 may be substantially free of second phase precipitates. The CMAS-reactive material 222 may be included at a level above its solubility in the thermal protection material 220. This may produce a super-saturated solid solution of the materials 220, 222 for the TBC 202. This method allows the columns 213 of Al-doped YSZ to grow unobstructed by second phase precipitates with minimal, if any, impact on strain tolerance of the columnar TBC structure. However, the TBC 202 may change as a result of exposure to high temperatures and/or CMAS material 240 as shown schematically in FIG. 3. The CMAS-reactive material 222 may precipitate as individual particles on the outer boundary 214 and inside the voids 210 at high temperatures. These particles may be between approximately twenty nanometers (20nm) to one micron in size. The CMAS-reactive material 222 may chemically react with CMAS material 240 that is introduced. Specifically, the CMAS-reactive material 222 may come out of solution into the voids 210 where it can chemically react with the CMAS material 240 and form precipitates 242 having crystal structures that limit (i.e., suppress, inhibit, etc.) further penetration of CMAS material 240 into the TBC 202. This reaction may increase the melting temperature or viscosity of the CMAS material 240, either of which may further reduce its penetration depth into the TBC 202. The precipitates 242 may be solid crystalline phases comprised of one or more constituents, such as anorthite, spinel, etc. The precipitates 242 may block the voids 210 or restrict further infiltration of liquid or vapor CMAS material 240 into the TBC 202.

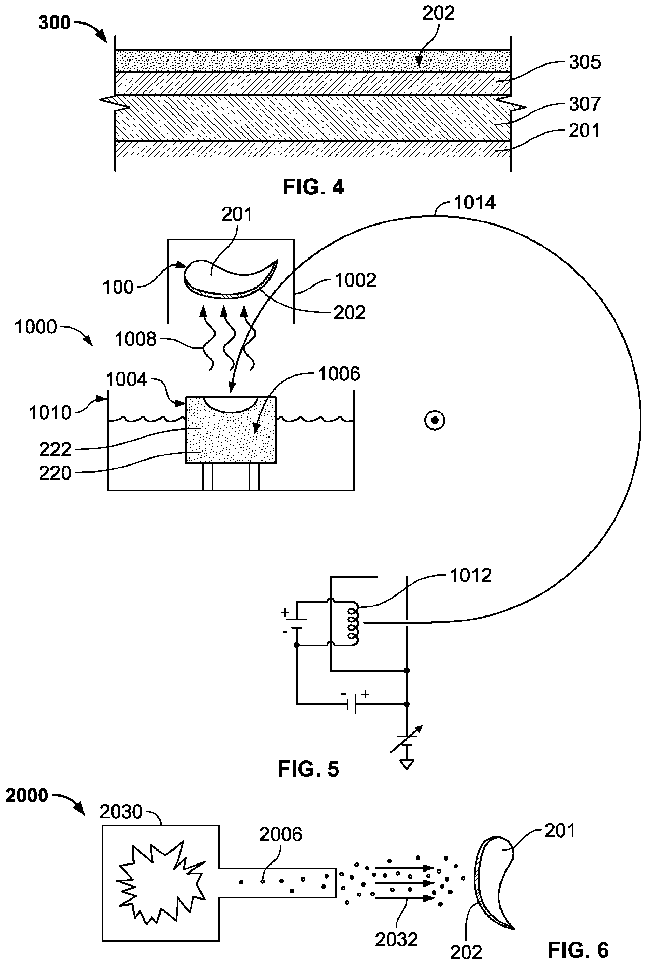

In additional embodiments represented in FIG. 4, the CMAS-resistant TBC 202 discussed above may be one of a plurality of thermal coating applications 300 on the part body 201. Each may be formed in independent coating manufacturing processes. For example, the TBC 202 may be an outermost one of the thermal coating applications 300. As such, the CMAS-reactive material 222 in the TBC 202 may be disposed on the outermost area and may define the thermal coating application that is furthest away from the part body 201. The plurality of thermal coating applications 300 may include at least one interior application that is disposed (in the thickness direction) between the TBC 202 and the body 201. Specifically, in the embodiments represented in FIG. 4, there may be a first thermal coating application 305 and a second thermal coating application 307 included; however, there may be any number of applications without departing from the scope of the present disclosure. The first and second thermal coating applications 305, 307 may be formed from conventional thermal barrier coating layers (TBC), such as rare-earth-doped zirconia ceramic. Moreover, in some embodiments, there may be alternating layers of conventional layers of rare-earth-doped zirconia ceramic and one or more CMAS-resistant TBCs 202 of the type discussed above. In these embodiments, the CMAS-resistant TBC 202 may define a predetermined percentage of the thermal coating applications 300. In some embodiments, the CMAS-resistant TBC 202 may define between ten percent (10%) and ninety percent (90%) of the total thickness of the thermal coating applications 300.

The TBC 202 may be formed on the part 200 using a number of different manufacturing methods, some of which will be discussed below. As will be discussed, these methods are efficient and cost effective. They can be employed repeatably for making parts at high volume. In some embodiments, the CMAS-resistant TBC 202 may be formed using electron-beam physical vapor deposition (EBPVD), air plasma spray (APS), suspension plasma spray (SPS), so-called SOL-GEL processes, or another suitable process.

Generally, the TBC 202 may be formed by delivering, directing, and/or depositing a coating material 1006 on a surface of the body 201. A flow of the coating material 1006 may be formed (e.g., by vapor, plasma spray, gas, plume, cloud, atomized particles or droplets, mist, etc.), and flow of the coating material 1006 and maybe delivered for deposition of the coating material on the surface of the body 201. During formation of the TBC 202, the flow of coating material 1006 may be directed to flow naturally and passively toward the body 201, or may be actively directed (e.g., sprayed) toward the body 201 with one or more implements. The TBC 202 may build-up and/or grow to a predetermined thickness on the body 201. The thermal protection material 220 (e.g., YSZ) and the CMAS-reactive material 222 (e.g., alumina) may be present in the vapor phase simultaneously so that both may be deposited together. Furthermore, in some embodiments, the materials 220, 222 may be applied as molten or semi-molten volatized particles (e.g., particles that contain YSZ and alumina).

In some embodiments of a manufacturing method 1000 represented in FIG. 5, a manufacturing method 1000 for the part 200 is illustrated according to example embodiments. As shown, the TBC 202 may be formed on the body 201 via an electron beam physical vapor deposition (EBPVD) method in some embodiments.

More specifically, the method 1000 may include providing the part body 201 (pre-coated body) within a vessel 1002. The vessel 1002 may be airtight so as to selectively contain a vacuum. The vessel 1002 may also contain a predetermined environment (e.g., a selectively heated environment and/or a selectively oxygen-enriched environment). Using the method 1000, the bond coat 206 may be formed on the part body 201. The bond coat 206 may formed in a conventional fashion and may be a slow-growing aluminum oxide scale formed at high temperatures within the vessel 1002 or otherwise.

Also, the method 1000 may include providing a source 1004 of coating material 1006. For example, in some embodiments, the source 1004 may include a solid ingot of the coating material 1006 within a liquid-cooled support structure 1010. The support structure 1010 may be coupled to or provided within the vessel 1002.

The ingot of coating material 1006 may include materials for forming both the thermal protection material 220 as well as the CMAS-reactive material 222. For example, the ingot may include rare-earth-doped zirconia (e.g., YSZ) that is doped with alumina, Al₂O₃, at predetermined weight percentages. In some embodiments, the alumina is included approximately two percent to four percent (2-4%) by weight of the ingot, whereas the rare-earth-doped zirconia makes up the remaining amount. In an embodiment, the alumina is included approximately two percent to four percent (2-4%) by weight of the ingot, and the remaining amount is 93% zirconia and 7% yttria by weight. In another embodiment, a rare-earth-doped zirconia ingot is used alongside a second ingot containing alumina and at least one other component (e.g., alumina and yttria, in amounts that achieve the desired weight ranges described above. The multiple ingots are simultaneously consumed to provide the desired chemistry for the TBC 202. Also, it will be appreciated that, in these embodiments, the ratio of CMAS-reactive material 222 to thermal protection material 220 in the ingot(s) may be substantially equal to the ratio of CMAS-reactive material 222 to thermal protection material 220 in the resulting TBC 202.

The coating material 1006 within the source 1004 may be heated to create a vapor 1008. More specifically, the source 1004 may be operably coupled to a filament 1012 made, for example, of tungsten. The ingot (an anode) may be bombarded with an electron beam 1014 given off by the filament 1012 under a vacuum. The electron beam 1014 causes atoms from the source 1004 to transform into the vapor 1008. The vapor 1008 may be directed toward the body 201 within the vessel 1002. More specifically, the pre-coated body 201 may be provided in the vessel 1002 with the bond coat 206 formed on predetermined areas. Other areas of the body 201 may be masked to prevent coating these areas. Then, as the electron beam 1014 vaporizes the coating material 1006, the vapor 1008 may precipitate into solid form (condense) on the bond coat layer of the part body 201. The columns 213 and voids 210 described above may grow progressively on the part body 201 to a predetermined thickness to thereby form the TBC 202. In some embodiments, alumina condenses on the body 201 together with YSZ, forming the TBC 202. Using this example, the alumina may be included at a level above its solubility in the YSZ. In some embodiments, this may produce a super-saturated solid solution of alumina in YSZ for the TBC 202. This method allows the columns 213 of Al-doped YSZ to grow unobstructed by second phase precipitates with minimal, if any, impact on strain tolerance of the columnar TBC structure.

In embodiments similar to FIG. 4, in which plural TBC layers are to be included, then the part body 201 may be provided with the TBC applications 305, 307 (conventional TBC layers). Subsequently, the TBC 202 may be formed as discussed above.

Additional embodiments of the manufacturing method 2000 are illustrated in FIG. 6. As shown, the TBC 202 may be formed on the body 201 via a thermal spray process. More specifically, an air plasma spray process may be used. Coating material 2006, including the thermal protection material 220 as well as the CMAS-reactive material 222, may be provided to a spray tool 2030. The coating material 2006 may be provided as powder that includes rare-earth-doped zirconia (e.g., YSZ) and aluminum-containing material (e.g., alumina). The powderized coating material 2006 may become molten or semi-molten and directed within a plasma jet 2032 (i.e., directed as a thermally-sprayed coating material 1006) for delivering the thermal protection and CMAS-reactive materials 220, 222 from the tool 2030 toward the body 201. Thus, the coating material 2006 may progressively grow and coat of the TBC 202 onto the body 201.

In further embodiments that include thermal spraying, the TBC 202 may be formed via a suspension plasma spray process. Moreover, the TBC 202 may be formed using a plasma-enhanced chemical vapor deposition process. Additionally, the TBC 202 may be formed using a so-called Sol-gel process or via a sputtering process. Furthermore, the TBC 202 may be formed using a hybrid technique that combines aspects of two or more of the described techniques (e.g., plasma spray physical vapor deposition (PS-PVD)).

It will be appreciated that multiple bodies 201 may be provided for substantially simultaneously forming TBCs 202 on a plurality of parts in one continuous process. In embodiments of FIG. 5, a plurality of bodies 201 may be provided at one time within the vessel 1002, and the vapor 1008 may be directed toward these bodies 201 for forming the TBCs 202 thereon. In embodiments represented in FIG. 6, a plurality of bodies 201 may be positioned in an area at once, and the jet 2032 may be directed toward the bodies 201 one after the other until the TBCs 202 are formed to the predetermined thickness.

Once the TBCs 202 are formed, the body 201 may be installed within the gas turbine engine 100. In some embodiments, the TBC 202 may be installed in the state represented in FIG. 2 and may subsequently provide thermal protection thereto. Also, during service, any CMAS 240 and the elevated operating temperatures of the engine 100 may cause the precipitates 242 to form for preventing further infiltration of CMAS 240 as discussed above and illustrated in FIG. 3.

In other embodiments, the body 201 (and the TBC 202 formed thereon) may be treated before installation on the gas turbine engine 100 and/or before the body 201 is put into full service on the gas turbine engine 100. For example, it may be desirable to form the precipitates 242 on the TBC 202 under predetermined, controlled conditions before the engine 100 is put into service. In some embodiments, after the TBC 202 is formed free of second phase precipitates (FIG. 2). Then, the TBC 202 may be selectively exposed to high temperature and to CMAS 240, thus forming the protective precipitates 242. Subsequently, the body 201 may be fully installed into the engine 100 and/or otherwise put into full operational service with significant protection against further intrusion of CMAS 240.

In summary, the TBC 202 may be strong and robust. Furthermore, the TBC 202 may be manufactured efficiently and cost-effectively.

In this document, relational terms such as first and second, and the like may be used solely to distinguish one entity or action from another entity or action without necessarily requiring or implying any actual such relationship or order between such entities or actions. Numerical ordinals such as "first," "second," "third," etc. simply denote different singles of a plurality and do not imply any order or sequence unless specifically defined by the claim language. The sequence of the text in any of the claims does not imply that process steps must be performed in a temporal or logical order according to such sequence unless it is specifically defined by the language of the claim. The process steps may be interchanged in any order without departing from the scope of the invention as long as such an interchange does not contradict the claim language and is not logically nonsensical.

Furthermore, depending on the context, words such as "connect" or "coupled to" used in describing a relationship between different elements do not imply that a direct physical connection must be made between these elements. For example, two elements may be connected to each other physically, electronically, logically, or in any other manner, through one or more additional elements.

While at least one exemplary embodiment has been presented in the foregoing detailed description of the invention, it should be appreciated that a vast number of variations exist. It should also be appreciated that the exemplary embodiment or exemplary embodiments are only examples, and are not intended to limit the scope, applicability, or configuration of the invention in any way. Rather, the foregoing detailed description will provide those skilled in the art with a convenient road map for implementing an exemplary embodiment of the invention. It being understood that various changes may be made in the function and arrangement of elements described in an exemplary embodiment without departing from the scope of the invention as set forth in the appended claims.

## Claims

1. A method of manufacturing a part with a CMAS-resistant thermal barrier coating (TBC) comprising:
providing a part body having a surface;
providing a source of coating material, the coating material including a thermal protection material and a CMAS-reactive material;
delivering the coating material from the source toward the surface of the part body to form the CMAS-resistant TBC on the surface, wherein the CMAS-resistant TBC includes both the thermal protection material and the CMAS-reactive material, and wherein the CMAS-reactive material is included as a substantially uniform distribution within the thermal protection material.

2. The method of claim 1, wherein forming the CMAS-resistant TBC comprises including the CMAS-reactive material at approximately one to five percent (1-5%) by weight of the CMAS-resistant TBC.

3. The method of claim 1, wherein the CMAS-reactive material is an aluminum-containing material and, optionally, the CMAS-reactive material included in the CMAS-resistant TBC is alumina.

4. The method of claim 1, wherein the thermal protection material includes a rare-earth-element and, optionally, the thermal protection material is a rare-earth-doped zirconia.

5. The method of claim 1, wherein delivering the coating material includes deposition of the coating material on the surface of the part body.

6. The method of claim 5, wherein providing the source includes providing at least one source that provides the thermal protection material and the CMAS-reactive material; and
further comprising creating a flow of the coating material from the source toward the surface.

7. The method of claim 5, further comprising creating a flow of the coating material, wherein deposition of the coating material includes spraying the flow of the coating material toward the surface of the part body.

8. The method of claim 5, further comprising creating a flow of the coating material, including creating the flow of at least one of vaporized, molten, or partly molten material containing the thermal protection material and the CMAS-reactive material.

9. The method of claim 1, further comprising creating a flow of the coating material, the flow simultaneously including the thermal protection material and the CMAS-reactive material therein.

10. The method of claim 1, wherein delivering the coating material to form the CMAS-resistant TBC includes:
forming the CMAS-resistant TBC with an inner boundary facing the surface of the part body part and an outer boundary facing away from the surface of the part body; and
providing the CMAS-reactive material in the substantially uniform distribution within the CMAS-resistant TBC from the inner boundary to the outer boundary.

11. The method of claim 10, wherein forming the CMAS-resistant TBC on the surface includes:
providing the CMAS-reactive material within the thermal protection material, the CMAS-reactive material configured to react with CMAS and form precipitates that limit further CMAS infiltration.

12. The method of claim 11, wherein forming the CMAS-resistant TBC includes forming a precipitate-free CMAS-resistant TBC, which is substantially free of second phase precipitates; and
further comprising treating the precipitate-free CMAS-resistant TBC to form the precipitates, which contain the CMAS-reactive material.

13. The method of claim 1, further comprising forming an intermediate thermal barrier coating on the part body, the intermediate thermal barrier coating including the surface; and
wherein delivering the coating material to form the CMAS-resistant TBC includes forming the CMAS-resistant TBC on the surface of the intermediate thermal barrier coating such that the intermediate thermal barrier coating is included between the part body and the CMAS-resistant TBC.

14. A thermally coated part manufactured according to the method of claim 1 comprising:
the part body; and
the CMAS-resistant TBC on the part body, the CMAS-resistant TBC including the thermal protection material and the CMAS-reactive material, wherein the CMAS-reactive material is included as the substantially uniform distribution within the thermal protection material.

15. The part of claim 14, wherein the CMAS-reactive material is included in the CMAS-resistant TBC at a level above its solubility in the thermal protection material.
